# EUROPEAN PATENT APPLICATION

(11) **EP 4 603 979 A1**
(43) Date of publication of application: **20.08.2025**
(21) Application number: 23887766.6
(22) Date of filing: 25.10.2023
(51) Int. Cl.: G06F 11/22, G01R 31/28

(54) **DELAY DETECTION AND ADJUSTMENT SYSTEM AND METHOD FOR CHIP, AND DEVICE AND COMPUTER STORAGE MEDIUM**

(30) Priority: 08.11.2022 CN 202211396357
(71) Applicant: Sanechips Technology Co., Ltd., Shenzhen, Guangdong 518055 (CN)
(72) Inventor: SHAN, Chuang, Shenzhen, Guangdong 518055 (CN); ZHU, Shaofei, Shenzhen, Guangdong 518055 (CN)
(74) Representative: Ziebig Hengelhaupt Intellectual Property Attorneys Patentanwaltskanzlei PartGmbB
(86) International application number: PCT/CN2023/126458
(87) International publication number: WO 2024/099075

(57) **Abstract**

The present application discloses a chip delay detection and adjustment system, method, device and computer storage medium. The system includes a replication link, a replication link, a collection module, a processor, a power voltage regulation interface and a lookup table. The collection module, the processor and the power voltage regulation interface are connected to the replication link in sequence; the power voltage regulation interface is connected to a chip, and a plurality of basic delay units are provided at the replication link. The lookup table is provided with at least one message for configuring the basic delay unit at the replication link. The collection module is configured for collecting timing detection results at the replication link, and performing time delay adjustment on the basic delay unit in response to the timing detection result matching the lookup table until detecting that an acquired timing detection result fails to match the lookup table. The processor is configured for generating a voltage regulation strategy according to all the timing detection results collected by the collection module, and adjusting a voltage of the chip by the power voltage regulation interface according to the voltage regulation strategy.

## Description

### CROSS-REFERENCE TO RELATED APPLICATIONS

The present application claims priority to Chinese Patent Application No. 202211396357.7, filed on November 8, 2022. The disclosure of the above-mentioned application is incorporated herein by reference in its entirety.

### TECHNICAL FIELD

The present application relates to but is not limited to the technical field of chip processing.

### BACKGROUND

At the present stage, chip power consumption and energy saving are becoming more and more important, and adjusting core voltage can produce good results. At present, the detection scheme of physical chip delay includes directly detecting the end of the real critical path of the chip to obtain the actual timing situation of the chip, but this detection method will affect the real path of the chip and the effectiveness of the detection, making the accuracy of the overall detection result lower, and thus the chip cannot be adjusted according to the overall detection result.

### SUMMARY

The present application provides a chip delay detection and adjustment system, a chip delay detection and adjustment method, a chip delay detection and adjustment device and a computer storage medium.

The present application provides a chip delay detection and adjustment system, which includes a replication link, a collection module, a processor, a power voltage regulation interface and a lookup table. The collection module, the processor and the power voltage regulation interface are connected to the replication link in sequence; the power voltage regulation interface is connected to a chip, and a plurality of basic delay units are provided at the replication link. The lookup table is provided with at least one message for configuring the basic delay unit at the replication link. The collection module is configured for collecting timing detection results at the replication link, and performing time delay adjustment on the basic delay unit in response to the timing detection result matching the lookup table until detecting that an acquired timing detection result fails to match the lookup table. The processor is configured for generating a voltage regulation strategy according to all the timing detection results collected by the collection module, and adjusting a voltage of the chip by the power voltage regulation interface according to the voltage regulation strategy.

In addition, the present application further provides a chip delay detection and adjustment method, applied to the chip delay detection and adjustment system described herein, including: collecting timing detection results at the replication link; performing time delay adjustment on the basic delay unit in response to the timing detection result matching the lookup table until detecting that an acquired timing detection result fails to match the lookup table; and generating a voltage regulation strategy according to all the collected timing detection results, and adjusting a voltage of the chip according to the voltage regulation strategy.

In addition, the present application further provides a chip delay detection and adjustment device, including: a memory, a processor, and a chip delay detection and adjustment program stored in the memory and executable on the processor, the chip delay detection and adjustment method described herein is implemented when the chip delay detection and adjustment program is executed by the processor.

In addition, the present application further provides a computer storage medium, a chip delay detection and adjustment program is stored on the computer storage medium, and the chip delay detection and adjustment method described herein is implemented when the chip delay detection and adjustment program is executed by the processor.

### BRIEF DESCRIPTION OF THE DRAWINGS

FIG. 1 is a schematic diagram of a chip delay detection and adjustment system according to the present application.
FIG. 2 is a schematic diagram of an overall structural framework of a chip delay detection and adjustment system according to the present application.
FIG. 3 is a schematic diagram of a critical path simulation structure of a chip delay detection and adjustment system according to the present application.
FIG. 4 is a schematic diagram of a corresponding relationship between voltage and transmission delay in a chip delay detection and adjustment system according to the present application.
FIG. 5 is a schematic diagram of a replication link in a chip delay detection and adjustment system according to the present application.
FIG. 6 is an exemplary structural diagram of a basic delay unit in a chip delay detection and adjustment system according to the present application.
FIG. 7 is a schematic flow chart of a chip delay detection and adjustment method according to the present application.
FIG. 8 is a schematic flow chart of a memory operation in a chip delay detection and adjustment method according to the present application.

### DETAILED DESCRIPTION OF THE EMBODIMENTS

It should be understood that the specific embodiments described here are only used to explain the present application and are not used to limit the present application.

The technical solutions in the embodiments according to the present application will be clearly and completely described below in conjunction with the accompanying drawings in the embodiments according to the present application. Obviously, the described embodiments are only a part of the embodiments according to the present application, and not all of the embodiments. Based on the embodiments in the present application, all other embodiments obtained by those skilled in the art without making creative labor fall within the scope of the present application.

It should be noted that in the embodiment of the present application, all directional indications (such as up, down, left, right, front, back or the like) are only used to explain the relative positional relationship, movement and so on between various components in a specific posture (as shown in the accompanying drawings). If the specific posture changes, the directional indication will also change accordingly.

In the present application, unless otherwise clearly stated and limited, the terms "connection", "fixed" and so on should be understood in a broad sense. For example, "connection" can be a fixed connection, a detachable connection or an integral body; it can be a mechanical connection or an electrical connection; it can be a direct connection or an indirect connection through an intermediate medium; it can be the internal connection of two elements or the interaction relationship between two elements, unless otherwise clearly defined. For those skilled in the art, the specific meanings of the above terms in the present application can be understood according to specific circumstances.

In addition, the descriptions of "first", "second" or the like in the present application are only for descriptive purposes and cannot be understood as indicating or implying the relative importance or implicitly indicating the quantity of the technical features indicated. Therefore, features defined as "first" and "second" may explicitly or implicitly include at least one of these features. In addition, the meaning of "and/or" appearing in the entire text includes three parallel solutions, taking "A and/or B" as an example, it includes solution A, or solution B, or a solution that satisfies both A and B at the same time. In addition, the technical solutions of various embodiments can be combined with each other, but it is based on that those of ordinary skill in the art can realize. When the combination of technical solutions is contradictory or cannot be realized, it should be considered that such combination of technical solutions does not exist and is not within the protection scope claimed by the present application.

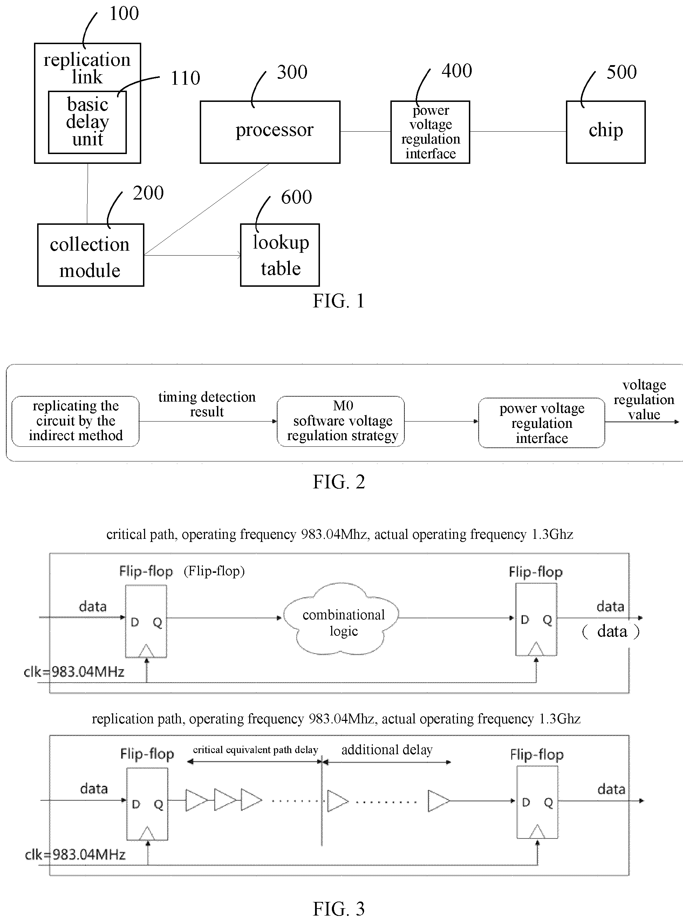

The present application proposes a chip delay detection and adjustment system. Referring to FIG. 1, in an embodiment, the chip delay detection and adjustment system may include a replication link 100, a collection module 200, a processor 300 and a power voltage regulation interface 400. The collection module 200, the processor 300 and the power voltage regulation interface 400 are connected to the replication link 100 in sequence. The power voltage regulation interface 400 is connected to a chip 500, and a plurality of basic delay units 110 are provided at the replication link 100. A lookup table 600 provided with at least one message for configuring the basic delay unit 110 at the replication link 100.

In an embodiment, the collection module 200 is configured for collecting timing detection results at the replication link 100, and performing time delay adjustment on the basic delay unit 110 in response to the timing detection result matching the lookup table 600 until detecting that an acquired timing detection result fails to match the lookup table 600. The processor 300 is configured for generating a voltage regulation strategy according to all the timing detection results collected by the collection module 200, and adjusting a voltage of the chip 500 by the power voltage regulation interface 400 according to the voltage regulation strategy.

In this embodiment, the method to detect the chip can be detect the end of the real path of the chip directly, or can be replicate the redundant critical path to perform timing monitoring. In order to improve the accuracy of chip delay detection, in this embodiment, a combination of coarse adjustment and fine adjustment is provided to detect chip delay, so as to better match the critical path, improve the matching accuracy, cope with the delay changes of replication circuit components in various environments, and match the critical path under multiple frequencies. In addition, in the chip delay detection and adjustment system of this embodiment, it further performs the delay detection by the matching circuit combining coarse adjustment and fine adjustment, and detect the negative slack (that is, the timing detection result) by replicating the circuit to detect the timing, and use the software voltage regulation strategy to drive voltage regulation circuit to adjust the voltage, thereby achieving energy saving. The replication link 100 includes a replication circuit.

Furthermore, because in 4G (the 4th Generation Communication System) and 5G (the 5th Generation Communication System) communication chips, as integrated circuits become larger and larger, the power consumption of integrated chips becomes more and more important, obtaining the physical delay of the chip by the method of this embodiment to reduce the core voltage is a very effective way to reduce power consumption. Therefore, this embodiment is mainly used in integrated circuit (IC) chips in 4G and 5G networks of communication systems; using the direct method and indirect method, and considering the process, business, temperature, aging and other scenarios, how to better detect and adjust the physical delay of the chip, thereby reducing power consumption. The direct method is to directly adjust the physical delay of the chip, and the indirect method is to detect the physical delay of the chip by the replication link 100. Therefore, in an embodiment, referring to FIG. 2, replicating the circuit by the indirect method first, obtaining the timing detection result, and adjusting the power voltage regulation interface by the MO (processor) software voltage regulation strategy, obtaining the voltage regulation value, and then adjusting the voltage of the chip according to the voltage regulation value. The indirect method of replicating the circuit can be to better match the real critical path by replicating the circuit. MO may be mainly used to implement the software voltage regulation strategy. The power voltage regulation interface may be controlled by the output result of the software voltage regulation strategy, and obtain the voltage regulation value, so as to adjust the voltage of the chip.

In addition, in order to ensure that the internal logic timing can work normally when P (process), V (voltage), T (temperature) and A (aging) changes, additional margin will be added to the voltage of the chip. However, in actual application scenarios, it is rare that all PVTA (process, voltage, temperature and aging) factors of the chip are in extreme conditions. In most cases, a relatively large protection band leads to a transitional negative slack, resulting in a waste of power consumption. Therefore, the voltage adjustment implementation principle of the chip delay detection and adjustment system in this embodiment can be to dynamically adjust the power supply voltage according to the actual situation of the current PVTA of the chip, and to keep the power supply voltage in a state with a relatively small margin under the premise of meeting the timing requirement, so as to achieve the purpose of saving power consumption. In addition, the chip delay detection and adjustment system further provides a basic circuit of an indirect method, which simulates the timing of the critical path by the replication link 100, the timing of the replication path will change with the critical path under different working conditions, so the voltage can be adjusted according to the timing state of the replication link 100. The pluralities of basic delay units 110 in the replication link 100 simulate the delay of the critical path in the chip in a cascaded manner. The basic delay unit 110 can be an inverter, an AND gate (AND is always 1), an OR gate (OR is always 0), etc. It can also be a buffer (register) or a mux (input selector).

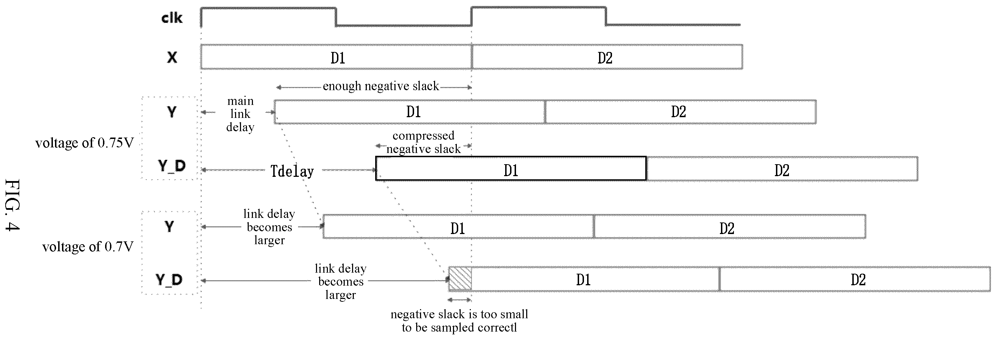

For example, as shown in FIG. 3, the critical path, an operating frequency of 983.04Mhz and an actual operating frequency of 1.3Ghz, that is, clk=983.04Mhz. Data is transmitted to the flip-flop (trigger), passes through the combinational logic, and then transmits the data out by the flip-flop. At this time, the physical delay of the critical path can be obtained by replicating the path with the indirect method. Therefore, the replication path can be set, an operating frequency of 983.04Mhz, an actual operating frequency of 1.3Ghz, that is, clk=983.04Mhz. Transmitting the data to the Flip-flop, after the critical equivalent path delay, additional delay, and then transmitting the data out by the Flip-flop. The replication link 100 includes a replication path. In the replication link 100, the transmission delay between two registers is simulated by cascade between the basic delay units 110. The more basic delay units 100 in cascade, the greater the transmission delay, the smaller the negative slack, and the lower the highest frequency that can be operated. Moreover, as the voltage gradually decreases, the transmission delay of the replication link 100 gradually increases, and the path with large transmission delay (small negative slack) will have a timing violation. At the same time, the path with small transmission delay (large negative slack) can still be sampled correctly, which is used to measure the maximum operating frequency that the circuit in the chip can actually operate during the voltage regulation process. For example, as shown in FIG. 4, if the critical path is X, the replication link 100 is Y, and the operating frequency is clk, there are negative slacks D1 and D2 in X and Y. At a voltage of 0.75V, Y is delayed by the main link, there is enough negative slack at this time, and after that (delay), a compressed negative slack is obtained. When the voltage of 0.75V is adjusted to the voltage of 0.7V, the link delay becomes larger, and there is a timing violation at this time, that is, the negative slack is too small to be sampled correctly.

Furthermore, in this embodiment, the replication link 100 includes a key equivalent path delay unit and an additional delay unit. The final timing detection result is obtained by a manner of performing coarse adjustment plus fine adjustment on the key equivalent path delay unit. The coarse adjustment can reduce the use of components and simplify the design, and fine adjustment can improve the matching critical path delay accuracy. The key equivalent path delay unit may include a buffer and a mux, the buffer delay has three delay specifications of 15ps, 30ps, and 40ps, and the mux delay is 30ps. The design of the critical path equivalent delay chain should simulate the critical path, and combined with the project requirements, and it should be able to cover the critical path delay at 491.52/737.28/983.04MHz. Furthermore, in actual design, a certain margin should be left. The critical path delay and the number of basic units required at 491.52/737.28/983.04MHz are shown in Table 1, with 30ps as the basic unit.

**Table 1**

| clock (MHz) | delay value (ps) | number of basic delay units required |
|---|---|---|
| 983.04 | 1017 | 34 |
| 737.28 | 1356 | 46 |
| 491.52 | 2035 | 68 |

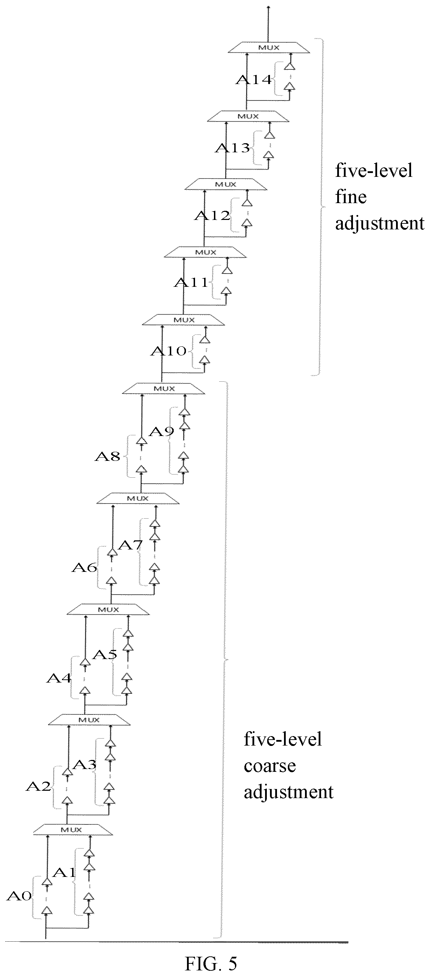

When setting the replication link 100, for example, as shown in FIG. 5, if performing 5-level coarse adjustment plus 5-level fine adjustment on the replication link 100, it can be that in the 5-level coarse adjustment stage, the signal data in the node A0 and node A1 flow into the first mux and then flow out, completing the first coarse adjustment; then, completing the second coarse adjustment through the first mux, node A2 and node A3, and the second mux; then, completing the third coarse adjustment through the second mux, node A4 and node A5, and the third mux; then, completing the fourth coarse adjustment through the third mux, node A6 and node A7, and the fourth mux; then, completing the fifth coarse adjustment through the fourth mux, node A8 and node A9, and the fifth mux. In the fine adjustment stage, completing the first fine adjustment through the fifth mux, node A10, and the sixth mux; completing the second fine adjustment through the sixth mux, node A11, and the seventh mux; completing the third fine adjustment through the seventh mux, node A12, and the eighth mux; completing the fourth fine adjustment through the eighth mux, node A13, and the ninth mux; and completing the fifth fine adjustment through the ninth mux, node A14, and the tenth mux. In addition, the corresponding buffer type and quantity can be set in each node in combination with Table 2.

**Table 2**

| node | buffer type | number (number) |
|---|---|---|
| A0 | 30ps delay buffer | 3 |
| A1 | 30ps delay buffer | 13 |
| A2 | 30ps delay buffer | 3 |
| A3 | 30ps delay buffer | 13 |
| A4 | 30ps delay buffer | 3 |
| A5 | 30ps delay buffer | 13 |
| A6 | 30ps delay buffer | 3 |
| A7 | 30ps delay buffer | 13 |
| A8 | 30ps delay buffer | 3 |
| A9 | 30ps delay buffer | 13 |
| A10 | 30ps delay buffer | 1 |
| A11 | 30ps delay buffer | 2 |
| A12 | 30ps delay buffer | 3 |
| A13 | 30ps delay buffer | 4 |
| A14 | 15ps delay buffer | 1 |

Obtaining the adjustable range of each level according to Table 2 above, as shown in Table 3 below.

**Table 3**

| Number of level | coarse adjustment level 1 | coarse adjustment level 2 | coarse adjustment level 3 | coarse adjustment level 4 | coarse adjustment level 5 | fine adjustment level 1 | fine adjustment level 2 | fine adjustment level 3 | fine adjustment level 4 | fine adjustment level 5 |
|---|---|---|---|---|---|---|---|---|---|---|
| mux 0 adjustable range | 4 | 4 | 4 | 4 | 4 | 1 | 1 | 1 | 1 | 1 |
| mux 1 adjustable range | 14 | 14 | 14 | 14 | 14 | 2 | 3 | 4 | 5 | 1.5 |

Performing permutations and combinations based on the above table 3, obtaining the number of basic delay units with adjustable levels and the matchable delay value in the replication link 100. Then, the timing detection result is collected by the collection module 200, matching the timing detection result with the lookup table 600. For example, when the buffer delay is 15ps and 30ps respectively, the adjustment accuracy of the designed critical path equivalent delay chain is 15ps, and the adjustment range is 750ps to 2565ps, with a step of 15ps. the critical path length matched at 983.04MHz is 1020ps, which is 3ps different from the real critical path; the critical path length matched at 737.28MHz is 1350ps, which is 6ps different from the real critical path; and the critical path length matched at 491.52MHz is 2040ps, which is 5ps different from the real critical path.

In this embodiment, the processor 300 can be a processor of different forms or different types, such as a processor for a desktop computer, a laptop computer, a tablet computer, an e-reader, or other wired or wireless electronic devices, etc., and can also be a MO (Cortex-MO, a 32-bit, three-stage pipeline RISC processor). The collection module collection module 200 can be a sensor with a timing collection function. The lookup table 600 can store the clock signal and the delay value of the critical path or the replication link 100, and the number of basic delay units required for the replication link 100. For example, as described in the above Table 1. It can also include buffer type and adjustment level, for example, as shown in the above Table 2 and Table 3.

Furthermore, the replication link is configured for simulating at least one critical path in the chip.

The critical path can be a path with the largest combinational logic delay in a synchronous logic circuit, or a sequential circuit that has a decisive influence on the design performance.

In this embodiment, in the chip delay detection and adjustment system, by providing a replication link, a collection module, a processor and a power voltage regulation interface connected to the replication link, and providing a lookup table, the collection module is configured for performing time delay adjustment on the basic delay unit after the collected timing detection results of the replication link match with the lookup table, until detecting that the acquired timing detection result fails to match the lookup table; the processor will generates a voltage regulation strategy according to all the collected timing detection results, and then adjusts the voltage of the chip by the power voltage regulation laser, so as to avoid the occurrence of affecting the effectiveness of the detection when directly detecting the end of the real critical path of the chip; by performing time delay adjustment on the replication link, the critical paths of multiple frequencies can be covered, thus improving the accuracy of chip delay detection, and generating the voltage regulation strategy according to the timing detection result to adjust the voltage of the chip, so that the chip delay can be accurately detected while saving energy.

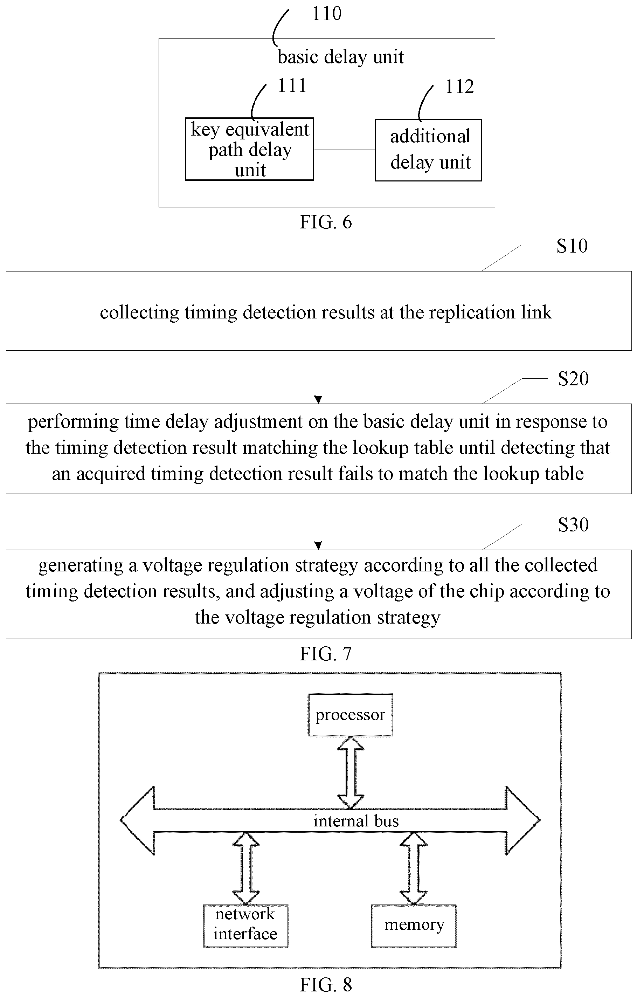

Furthermore, based on the above embodiment, another embodiment of the chip delay detection and adjustment system of the present application is proposed. Referring to FIG. 6, the basic delay unit 110 includes a key equivalent path delay unit 111 and an additional delay unit 112, and the key equivalent path delay unit 111 includes at least one buffer and a data selector.

In this embodiment, the key equivalent path delay unit 111 can be configured to simulate the delay of the critical path. The additional delay unit 112 can be configured to simulate an instance pseudo-example. Moreover, the key equivalent path delay unit 111 includes at least one buffer and two data selectors mux, and the data selector mux is connected to another data selector mux by the buffer. A plurality of buffers can be provided, that is, it can be determined according to the above Table 1. That is, it can be that firstly determining the delay value corresponding to the critical path under different clocks, and then calculating the sum value of the delay values corresponding to all key equivalent path delay units 111; when the sum value is close to the delay value corresponding to the critical path, such as the sum value equals to the delay value corresponding to the critical path, or the difference between the delay value corresponding to the critical path and the sum is less than a preset value, determining the number of buffers in the key equivalent path delay unit 111. Two data selectors can be provided.

In addition, in a scenario, the key equivalent path delay unit 111 can also be constructed using a logic gate or a combination of a logic gate and an inverter.

In this embodiment, by providing the key equivalent path delay unit 111 and the additional delay unit 112 in the basic delay unit 110, the critical path in the chip can be simulated more accurately.

Furthermore, the collection module 200 is configured for determining all clock signals preset in the lookup table 600 and first delay values corresponding to each of the clock signals, determining that the timing detection result matches the lookup table 600 after detecting that the timing detection result matches each of the first delay values, performing time delay adjustment on the basic delay unit 110 according to a preset delay adjustment value, continuing to perform the collecting the timing detection result in the replication link 100 until detecting that the acquired timing detection result fails to match the lookup table 600, and taking the timing detection result that does not match the lookup table 600 as a target timing detection result. Each of the first delay values is provided with a first delay value failing to match the target timing detection result.

In this embodiment, after the collection module 200 collects the timing detection result of the replication link 100, it is necessary to determine all the clock signals in the lookup table and the first delay value corresponding thereto. The clock signals are clock signals commonly used by the critical path, such as 983.04MHz, 737.28MHz and 491.52MHz, etc. When the clock signal is 983.04MHz, the first delay value is 1017ps; when the clock signal is 737.28MHz, the first delay value is 1356ps; when the clock signal is 491.52MHz, the first delay value is 2035ps. Then, detecting whether the timing detection result matches each first delay value, that is, detecting whether there is a delay value matching the first delay value corresponding to each clock signal in the timing detection result. If there is a delay value matching the first delay value corresponding to each clock signal in the timing detection result, determining that the timing detection result matches the lookup table 600. At this time, the basic delay unit 110 can be adjusted according to the delay adjustment value set in advance, until the latest timing detection result does not match the lookup table 600.

In this embodiment, the collection module 200 performs time delay adjustment when detecting that the timing detection result matches the first delay value corresponding to each clock signal in the lookup table 600, until there is a mismatch and a timing violation occurs, thereby improving the accuracy of chip delay detection.

Furthermore, the collection module 200 is configured for calculating a second delay value corresponding to a clock in the timing detection result, detecting an error value between the first delay value corresponding to a clock in the lookup table 600 and the second delay value, and determining that the first delay value matches the second delay value in response to the error value matching a preset threshold interval range.

In this embodiment, firstly calculating the second delay value corresponding to each clock in the timing detection result, and calculating the error value between the first delay value in the lookup table and the second delay value in the timing detection result under the same clock; determining that the first delay value matches the second delay value when the error value is within a certain preset threshold interval range; if the error value is not within a certain preset threshold interval range, determining that the first delay value fails to match the second delay value. At this time, it can be determined that there is a timing violation in the replication link 100.

In this embodiment, the collection module 200 determines that the first delay value and the second delay value match each other when the error value between the first delay value in the lookup table 600 and the second delay value in the timing detection result matches the preset threshold interval range under the same clock, thereby ensuring the effective delay detection.

Furthermore, the collection module 200 is configured for increasing or decreasing a delay value corresponding to the key equivalent path delay unit 111 by a preset delay adjustment value in response to adjusting the delay value corresponding to the key equivalent path delay unit 111.

In this embodiment, when adjusting the delay value corresponding to the key equivalent path delay unit 111, the delay value corresponding to each buffer and the delay value corresponding to the data selector can be adjusted, such as increasing the delay adjustment value, or reducing the delay adjustment value. The delay adjustment value can be a fixed value set in advance by the user, such as 1ps. Moreover, when adjusting the delay value corresponding to the key equivalent path delay unit 111, it can be adjusted n times according to the delay adjustment value until a timing violation is detected, that is, the latest timing detection result obtained cannot match the lookup table. The n is a natural number greater than 1.

For example, when the delay buffer delay is 15ps and 30ps respectively, the designed critical path equivalent delay chain has an adjustment accuracy of 15ps, an adjustment range of 750ps to 2565ps, and a step of 15ps. If the critical path length matched at 983.04MHz in the lookup table 600 is 1020ps, which is 3ps different from the real critical path; the critical path length matched at 737.28MHz is 1350ps, which is 6ps different from the real critical path; the critical path length matched at 491.52MHz is 2040ps, which is 5ps different from the real critical path.

At this time, if the delay adjustment value is 1ps, then the delay can be reduced by 1ps. At this time, the buffer delay is 14ps and 29ps respectively, the mux delay is 29ps, and obtaining the matching delay value of the equivalent delay chain of the critical path at this time. At this time, the critical path length matched at 983.04MHz in the lookup table 600 is 1015ps, which is 2ps different from the real critical path; the critical path length matched at 737.28MHz is 1363ps, which is 7ps different from the real critical path; the critical path length matched at 491.52MHz is 2030ps, which is 5ps different from the real critical path.

Continuing to perform time delay adjustment, reducing the delay by 2ps: the buffer delay is 13ps and 28ps respectively, the mux delay is 28ps, and obtaining the matching delay value of the equivalent delay chain of the critical path at this time. At this time, according to the lookup table 600, the critical path length matched at 983.04MHz is 1021ps, which differs from the real critical path by 4ps; the critical path length matched at 737.28MHz is 1357ps, which differs from the real critical path by 1ps; the critical path length matched at 491.52MHz is 2029ps, which differs from the real critical path by 6ps.

Continuing to perform time delay adjustment, and reducing the delay by 3ps: the buffer delay is 13ps and 28ps respectively, the mux delay is 28ps, and obtaining the matching delay value of the equivalent delay chain of the critical path at this time. At this time, according to the lookup table 600, the critical path length matched at 983.04MHz is 1011ps, which is 6ps different from the real critical path; the critical path length matched at 737.28MHz is 1362ps, which is 6ps different from the real critical path; the critical path length matched at 491.52MHz is 2037ps, which is 2ps different from the real critical path.

Continuing to perform time delay adjustment, and reducing the delay by 4ps: the buffer delay is 11ps and 26ps respectively, the mux delay is 26ps, and obtaining the matching delay value of the equivalent delay chain of the critical path at this time. At this time, according to the lookup table 600, the critical path length matched at 983.04MHz is 1014ps, which is 3ps different from the real critical path; the critical path length matched at 737.28MHz is 1352ps, which is 4ps different from the real critical path; the critical path length matched at 491.52MHz is 2039ps, which is 4ps different from the real critical path.

Continuing to perform time delay adjustment, and reducing the delay by 5ps: the buffer delay is 10ps and 25ps respectively, the mux delay is 25ps, and obtaining the matching delay value of the equivalent delay chain of the critical path at this time. At this time, according to the lookup table 600, the critical path length matched at 983.04MHz is 1010ps, which is 7ps different from the real critical path; the critical path length matched at 737.28MHz is 1360ps, which is 4ps different from the real critical path; the critical path length matched at 491.52MHz is 2035ps, which is 0ps different from the real critical path.

Continuing to perform time delay adjustment, and reducing the delay by 6ps: the buffer delay is 9ps and 24ps respectively, the mux delay is 24ps, and obtaining the matching delay value of the equivalent delay chain of the critical path at this time. At this time, according to the lookup table 600, the critical path length matched at 983.04MHz is 1017ps, which differs from the real critical path by 0ps; the critical path length matched at 737.28MHz is 1353ps, which differs from the real critical path by 3ps; the critical path length matched at 491.52MHz is 2040ps, which differs from the real critical path by 5ps.

Continuing to perform time delay adjustment, and reducing the delay by 7ps: the buffer delay is 8ps and 23ps respectively, the mux delay is 23ps, and obtaining the matching delay value of the equivalent delay chain of the critical path at this time. At this time, according to the lookup table 600, the critical path at 491.52MHz cannot be matched, that is, it does not match the lookup table 600 at this time, and stopping the operation of reducing the preset delay adjustment value.

In addition, when performing time delay adjustment, it further can increase the corresponding time delay adjustment value, such as adding 1ps to the delay: the buffer delay is 16ps and 31ps respectively, and the mux delay is 31ps, and obtaining the matching delay value of the equivalent delay chain of the critical path at this time. At this time, according to the lookup table 600, the critical path length matched at 983.04MHz is 1023ps, which is 6ps different from the real critical path; the critical path length matched at 737.28MHz is 1349ps, which is 7ps different from the real critical path; the critical path length matched at 491.52MHz is 2031ps, which is 4ps different from the real critical path.

Continuing to perform time delay adjustment, and adding 2ps to the delay: the buffer delay is 17ps and 32ps respectively, the mux delay is 32ps, and obtaining the matching delay value of the equivalent delay chain of the critical path at this time. At this time, according to the lookup table 600, the critical path length matched at 983.04MHz is 1024ps, which is 7ps different from the real critical path; the critical path length matched at 737.28MHz is 1364ps, which is 5ps different from the real critical path; the critical path length matched at 491.52MHz is 2033ps, which is 2ps different from the real critical path.

Continuing to perform time delay adjustment, and adding 3ps to the delay: the buffer delay is 18ps and 33ps respectively, the mux delay is 33ps, and obtaining the matching delay value of the equivalent delay chain of the critical path at this time. At this time, according to lookup table 600, the critical path length matched at 983.04MHz is 1023ps, which is 6ps different from the real critical path; the critical path length matched at 737.28MHz is 1353ps, which is 3ps different from the real critical path; the critical path length matched at 491.52MHz is 2031ps, which is 4ps different from the real critical path.

Continuing to perform time delay adjustment, and adding 4ps to the delay: the buffer delay is 19ps and 34ps respectively, the mux delay is 34ps, and obtaining the matching delay value of the equivalent delay chain of the critical path at this time. At this time, according to the lookup table 600, the critical path length matched at 983.04MHz is 1020ps, which is 3ps different from the real critical path; the critical path length matched at 737.28MHz is 1360ps, which is 4ps different from the real critical path; the critical path length matched at 491.52MHz is 2040ps, which is 5ps different from the real critical path.

Continuing to perform time delay adjustment, and adding Sps to the delay: the buffer delay is 20ps and 35ps respectively, the mux delay is 35ps, and obtaining the matching delay value of the equivalent delay chain of the critical path at this time. At this time, according to the lookup table 600, the critical path length matched at 983.04MHz is 1015ps, which is 2ps different from the real critical path; the critical path length matched at 737.28MHz is 1350ps, which is 6ps different from the real critical path; the critical path length matched at 491.52MHz is 2030ps, which is 5ps different from the real critical path.

Continuing to perform time delay adjustment, and adding 6ps to the delay: the buffer delay is 21ps and 36ps respectively, the mux delay is 36ps, and obtaining the matching delay value of the equivalent delay chain of the critical path at this time. At this time, according to the lookup table 600, the critical path length matched at 983.04MHz is 1008ps, which is 9ps different from the real critical path; the critical path length matched at 737.28MHz is 1353ps, which is 3ps different from the real critical path; the critical path length matched at 491.52MHz is 2037ps, which is 2ps different from the real critical path.

Continuing to perform time delay adjustment, and adding 7ps to the delay: the buffer delays are 22ps and 37ps respectively, and the mux delay is 37ps, and obtaining the matching delay value of the equivalent delay chain of the critical path at this time. At this time, according to lookup table 600, the critical path length matched at 983.04MHz is 1021ps, which is 4ps different from the real critical path; the critical path length matched at 737.28MHz is 1354ps, which is 2ps different from the real critical path; the critical path length matched at 491.52MHz is 2035ps, which is 0ps different from the real critical path.

Continuing to perform time delay adjustment, and adding 8ps to the delay: the buffer delay is 23ps and 38ps respectively, the mux delay is 38ps, and obtaining the matching delay value of the equivalent delay chain of the critical path at this time. At this time, according to the lookup table 600, the critical path length matched at 983.04MHz is 1011ps, which is 6ps different from the real critical path; the critical path length matched at 737.28MHz is 1353ps, which is 3ps different from the real critical path; the critical path length matched at 491.52MHz is 2037ps, which is 2ps different from the real critical path.

Continuing to perform time delay adjustment, and adding 9ps to the delay: the buffer delay is 24ps and 39ps respectively, the mux delay is 39ps, and obtaining the matching delay value of the equivalent delay chain of the critical path at this time. At this time, according to the lookup table 600, the critical path length matched at 983.04MHz is 1014ps, which is 3ps different from the real critical path; the critical path length matched at 737.28MHz is 1350ps, which is 6ps different from the real critical path; the critical path length matched at 491.52MHz is 2028ps, which is 7ps different from the real critical path.

Continuing to perform time delay adjustment, and adding 10ps to the delay: the buffer delay is 25ps and 40ps respectively, the mux delay is 40ps, and obtaining the matching delay value of the equivalent delay chain of the critical path at this time. At this time, according to the lookup table 600, the critical path length matched at 983.04MHz is 1025ps, which is 8ps different from the real critical path; the critical path length matched at 737.28MHz is 1360ps, which is 4ps different from the real critical path; the critical path length matched at 491.52MHz is 2035ps, which is 5ps different from the real critical path.

Continuing to perform time delay adjustment, and adding 11ps delay: the buffer delay is 26ps and 41ps respectively, the mux delay is 40ps, and obtaining the matching delay value of the equivalent delay chain of the critical path at this time. At this time, according to the lookup table 600, the critical path at 983.04MHz cannot be matched, that is, it does not match the lookup table 600 at this time, and stopping the operation of increasing the preset delay adjustment value.

Based on the above operations of increasing the delay adjustment value and decreasing the delay adjustment value on the key equivalent path delay unit 111, a table of delay changes and matching errors of the key equivalent path delay unit 111 at various frequencies can be obtained, as shown in Table 4 below.

| | -6 | -5 | -4 | -3 | -2 | -1 | 0 |
|---|---|---|---|---|---|---|---|
| 983.04MHz | 0 | 7 | 3 | 6 | 4 | 2 | 3 |
| 737.28MHz | 3 | 4 | 4 | 6 | 1 | 7 | 6 |
| 491.52MHz | 5 | 0 | 4 | 2 | 6 | 5 | 5 |

**Table 4**

| | 1 | 2 | 3 | 4 | 5 | 6 | 7 | 8 | 9 | 10 | average error | error percentage |
|---|---|---|---|---|---|---|---|---|---|---|---|---|
| 983.04MHz | 6 | 7 | 6 | 3 | 2 | 9 | 4 | 6 | 3 | 8 | 4.65 | 0.46% |
| 737.28MHz | 7 | 5 | 3 | 4 | 6 | 3 | 2 | 3 | 6 | 4 | 4.35 | 0.32% |
| 491.52MHz | 4 | 2 | 4 | 5 | 5 | 2 | 0 | 2 | 7 | 5 | 3.71 | 0.18% |

From the above data, it can be seen that the delay chain design of the critical path can be well matched to the critical path at 491.52/737.28/983.04MHz frequency. Furthermore, under different conditions, the basic component delay changes from -6ps to +10ps, and the delay chain design of the critical path can also be well matched.

In this embodiment, the delay value corresponding to the key equivalent path delay unit is increased or decreased by a preset delay adjustment value until a timing violation occurs, thereby ensuring the effectiveness of delay detection.

Furthermore, the processor 300 is configured for obtaining all timing detection results collected by the collection module 200, determining a corresponding number of the timing detection results failing to match the lookup table 600 in each of the timing detection results, taking a boost operation as the voltage regulation strategy in response to that the number is greater than a maximum value of a preset configuration threshold, and taking a buck operation as the voltage regulation strategy in response to that the number is less than a minimum value of the preset configuration threshold.

In this embodiment, after the processor 300 obtain all the timing detection results collected by the collection module 200, determining the number of timing violations in each timing detection result; when there is a timing violation in the timing detection result, the timing detection result fails to match the lookup table 600. The timing violation may be a negative slack.

Detecting whether the number of timing violations is greater than the maximum value of the preset configuration threshold, or less than the minimum value of the preset configuration threshold. The maximum value of the preset configuration threshold is greater than the minimum value of the preset configuration threshold, and both can be set by the user according to his own experience. Furthermore, after the number of timing violations is greater than the maximum value of the preset configuration threshold, performing a boost operation, and it can be that performing the boost processing on the voltage of the chip by the power voltage regulation interface 400. After the number of timing violations is less than the value of the preset configuration threshold value, performing a buck operation, and it can be that performing the buck processing on the voltage of the chip by the power voltage regulation interface 400. The voltage regulation interface 400 can be at least one of avsbus (Adaptive Voltage Scaling Bus), i2c (Inter-Integrated Circuit) and pvid (Port-base VLAN ID). Furthermore, after completing the voltage adjustment of the chip, it can continue to perform the delay detection of the chip by this embodiment.

In this embodiment, performing the boost operation or the buck operation according to the number of timing violations in the timing detection result, so as to achieve energy saving.

In addition, referring to FIG. 7, the present application further proposes a chip delay detection method, which is applied to the chip delay detection system in any of the above-mentioned embodiments, including: step S10, collecting timing detection results at the replication link; step S20, performing time delay adjustment on the basic delay unit in response to the timing detection result matching the lookup table until detecting that an acquired timing detection result fails to match the lookup table; and step S30, generating a voltage regulation strategy according to all the collected timing detection results, and adjusting a voltage of the chip according to the voltage regulation strategy.

The exemplary implementation of the computer-readable storage medium of the present application is basically the same as the various implementations of the chip delay detection and adjustment system described above, and will not be repeated here.

In addition, FIG. 8 is a schematic diagram of the structure of the electronic device of the present application. In an embodiment, as shown in FIG. 8, at the hardware level, the electronic device includes a processor; in an embodiment, the electronic device further includes an internal bus, a network interface, and a memory. The memory may include a memory, such as a high-speed random access memory (RAM), and may also include a non-volatile memory, such as at least one disk storage, etc. Certainly, the electronic device may further include hardware required for other services. The processor, the network interface and the memory can be interconnected by an internal bus, and the internal bus can be an ISA (Industry Standard Architecture) bus, a **PCI** (Peripheral Component Interconnect) bus or an EISA (Extended Industry Standard Architecture) bus, etc. The bus can be divided into an address bus, a data bus, a control bus, etc. For ease of representation, only one bidirectional arrow is used in FIG. 8, but it does not mean that there is only one bus or one type of bus. The memory is used to store programs. Exemplarily, the program may include a program code, and the program code includes computer operation instructions. The processor reads the corresponding computer program from the non-volatile memory into the memory and then runs it, forming a shared resource access control device at the logical level. The processor executes the program stored in the memory and can be used to execute the steps of the above-mentioned chip delay detection and adjustment method.

In addition, the present application further provides a chip delay detection and adjustment device. The chip delay detection and adjustment device includes a memory, a processor, and a chip delay detection and adjustment program stored in the memory and executable on the processor. The processor is configured to execute the chip delay detection and adjustment program, so as to implement the steps of each implementation of the above-mentioned chip delay detection and adjustment method.

The present application further provides a computer storage medium, which can be a computer-readable storage medium. The computer-readable storage medium stores one or more programs, and the one or more programs can further be executed by one or more processors to implement the steps of each implementation of the above-mentioned chip delay detection and adjustment method.

The exemplary implementation of the computer-readable storage medium of the present application is basically the same as the implementation of the above-mentioned chip delay detection and adjustment method, and will not be repeated here.

It should be noted that, in the present application, the terms "comprise", "include" or any other variation thereof are intended to cover a non-exclusive inclusion, such that a process, method, article or system that includes a list of elements not only includes those elements, but also includes other elements not expressly listed, or also includes elements inherent to the process, method, article or system. In a case of without further restrictions, an element defined by the statement "includes......" does not exclude the existence of other identical elements in a process, method, article or system that includes this element.

The above serial numbers of the embodiments of the present application are only for description and do not represent the advantages and disadvantages of the embodiments.

By the above description of the embodiments, those skilled in the art can clearly understand that the methods of the above embodiments can be implemented by means of software plus the necessary general hardware platform, and they can also be done by hardware certainly, but in many cases the former is the better implementation. Based on this understanding, the technical solution of the present application essentially or the part that contributes to the related art can be embodied in the form of a software product, the computer software product is stored in a storage medium (such as read-only memory/random access memory (ROM/RAM), disk, optical disk), which includes several instructions to cause a terminal device (which can be a mobile phone, computer, server, or network device, etc.) to execute the methods described in various embodiments of the present application.

The above are only some embodiments of the present application, and are not intended to limit the scope of the present application. Under the concept of the present application, any equivalent structure transformation made by using the description and accompanying drawings of the present application, or directly or indirectly applied in other related technical fields, is included within the scope of the present application.

## Claims

1. A chip delay detection and adjustment system, **characterized by** comprising:
a replication link, a collection module, a processor and a power voltage regulation interface, wherein the collection module, the processor and the power voltage regulation interface are connected to the replication link in sequence; the power voltage regulation interface is connected to a chip, and a plurality of basic delay units are provided at the replication link; and
a lookup table provided with at least one message for configuring the basic delay unit at the replication link;
wherein the collection module is configured for collecting timing detection results at the replication link, and performing time delay adjustment on the basic delay unit in response to the timing detection result matching the lookup table until detecting that an acquired timing detection result fails to match the lookup table; and
the processor is configured for generating a voltage regulation strategy according to all the timing detection results collected by the collection module, and adjusting a voltage of the chip by the power voltage regulation interface according to the voltage regulation strategy.

2. The chip delay detection and adjustment system according to claim 1, wherein the replication link is configured for simulating at least one critical path in the chip.

3. The chip delay detection and adjustment system according to claim 1, wherein the basic delay unit comprises a key equivalent path delay unit and an additional delay unit, and the key equivalent path delay unit comprises at least one buffer and a data selector.

4. The chip delay detection and adjustment system according to claim 3, wherein the collection module is configured for determining all clock signals preset in the lookup table and first delay values corresponding to each of the clock signals, determining that the timing detection result matches the lookup table after detecting that the timing detection result matches each of the first delay values, performing time delay adjustment on the basic delay unit according to a preset delay adjustment value, continuing to perform the collecting the timing detection result in the replication link until detecting that the acquired timing detection result fails to match the lookup table, and taking the timing detection result that does not match the lookup table as a target timing detection result; wherein each of the first delay values is provided with a first delay value failing to match the target timing detection result.

5. The chip delay detection and adjustment system according to claim 4, wherein the collection module is configured for calculating a second delay value corresponding to a clock in the timing detection result, detecting an error value between the first delay value corresponding to a clock in the lookup table and the second delay value, and determining that the first delay value matches the second delay value in response to the error value matching a preset threshold interval range.

6. The chip delay detection and adjustment system according to claim 4, wherein the collection module is configured for increasing or decreasing a delay value corresponding to the key equivalent path delay unit by a preset delay adjustment value in response to adjusting the delay value corresponding to the key equivalent path delay unit.

7. The chip delay detection and adjustment system according to claim 1, wherein the processor is configured for obtaining all the timing detection results collected by the collection module, determining a corresponding number of the timing detection results failing to match the lookup table in each of the timing detection results, taking a boost operation as the voltage regulation strategy in response to that the number is greater than a maximum value of a preset configuration threshold, and taking a buck operation as the voltage regulation strategy in response to that the number is less than a minimum value of the preset configuration threshold.

8. A chip delay detection and adjustment method, applied to the chip delay detection and adjustment system according to any one of claims 1 to 7, **characterized by** comprising:
collecting timing detection results at the replication link;
performing time delay adjustment on the basic delay unit in response to the timing detection result matching the lookup table until detecting that an acquired timing detection result fails to match the lookup table; and
generating a voltage regulation strategy according to all the collected timing detection results, and adjusting a voltage of the chip according to the voltage regulation strategy.

9. A chip delay detection and adjustment device, **characterized by** comprising: a memory, a processor, and a chip delay detection and adjustment program stored in the memory and executable on the processor, wherein the chip delay detection and adjustment method according to claim 8 is implemented when the chip delay detection and adjustment program is executed by the processor.

10. A computer storage medium, wherein a chip delay detection and adjustment program is stored on the computer storage medium, and the chip delay detection and adjustment method according to claim 8 is implemented when the chip delay detection and adjustment program is executed by a processor.
